# EUROPEAN PATENT SPECIFICATION

(11) **EP 4 312 366 B1**
(45) Date of publication and mention of the grant of the patent: **02.12.2026**
(21) Application number: 23177971.1
(22) Date of filing: 07.06.2023
(51) Int. Cl.: H03F 3/30, H03F 3/345, H03F 3/45, G05F 1/46, G05F 1/575

(54) **CIRCUIT WITH A PSEUDO CLASS-AB STRUCTURE**
SCHALTUNG MIT EINER PSEUDO-KLASSE-AB STRUKTUR
CIRCUIT AVEC UNE STRUCTURE DE PSEUDO CLASSE AB

(30) Priority: 28.07.2022 US 202263369667 P; 09.12.2022 US 202263386688 P; 11.04.2023 US 202318298425
(43) Date of publication of application: 31.01.2024
(73) Proprietor: MediaTek Inc., Hsinchu City 30078 (TW)
(72) Inventor: TSAI, Chih-Hou, Hsinchu City (TW); LIN, Zhao-Hui, Hsinchu City (TW); KO, Ting-Yu, Hsinchu City (TW); CHANG, Shu-Lin, Hsinchu City (TW); CHENG, Chien-Yuan, Hsinchu City (TW); LU, Shao-Yung, Hsinchu City (TW)
(74) Representative: Wright, Howard Hugh Burnby

(56) References cited:
- WO-A1-01/37422
- US-A- 4 038 607
- US-A1- 2013 154 863
- US-B1- 6 707 340

## Description

### Field of the Invention

The present invention relates to the output stage design of a circuit.

### Description of the Related Art

In high drive current applications, the input and output linearity is a design bottleneck. The circuit bandwidth, power consumption, and circuit size should all be taken into consideration.

A class-A structure with good linearity has poor power efficiency. A class-B structure with good power efficiency has poor linearity.

A class-AB structure that has acceptable performance in both linearity and power efficiency may suffer from insufficient headroom.

WO 01/37422 A1 shows an amplifier but is silent regarding low-voltage domain bias design.

US 2013/154863 A1 shows a differential amplified but is silent regarding low-voltage domain bias design.

### BRIEF SUMMARY OF THE INVENTION

A circuit with sufficient headroom that performs well in terms of linearity and power efficiency is shown.

A circuit in accordance with the present invention is set out in the accompanying claims. Such a pseudo class-AB structure results in good performance with low-frequency signals.

In an exemplary embodiment, the first voltage is lower than the second voltage for a low-voltage design.

In an exemplary embodiment, the circuit is in a differential form, such as implementing a differential amplifier.

In another exemplary embodiment, the circuit is in a single end form, such as implementing a low-dropout regulator.

The bias circuit might further comprise: a diode-connected NMOS, having a source terminal coupled to ground, wherein a drain terminal and a gate terminal of the diode-connected NMOS are connected together, and the diode-connected NMOS is biased by a third bias current; a second operational amplifier, having a first input terminal coupled to the gate terminal of the diode-connected NMOS, a second input terminal coupled to the second end of the replicated impedance component, and an output terminal; and a first current NMOS, having a gate terminal coupled to the output terminal of the second operational amplifier, a source terminal coupled to the ground, a drain terminal coupled to the second end of the replicated impedance component, and an output terminal.

The circuit might further comprise a second current PMOS, having a gate terminal coupled to the gate terminal of the first current PMOS, a source terminal coupled to the power line, and a drain terminal coupled to a third connection node that couples the parallel-connected first capacitor and first impedance component with the gate terminal of the first PMOS.

The circuit might further comprise: a second current NMOS, having a gate terminal coupled to the gate terminal of the first current NMOS, a source terminal coupled to the ground, and a drain terminal coupled to a seventh connection node that couples the parallel-connected first capacitor and first impedance component with the gate terminal of the first NMOS.

The bias circuit might further comprise: a sixth current PMOS, having a source terminal coupled to the power line, a drain terminal coupled to the second end of the replicated impedance component, and a gate terminal; and a third current NMOS, having a source terminal coupled to the ground, a drain terminal coupled to the first end of the replicated impedance component, and a gate terminal.

The circuit might further comprise: a seventh current PMOS, having a source terminal coupled to the power line, a drain terminal coupled to the seventh connection node that couples the parallel-connected first capacitor and first impedance component with the gate terminal of the first NMOS, and a gate terminal coupled to the gate terminal of the sixth current PMOS; and a fourth current NMOS, having a source terminal coupled to the ground, a drain terminal coupled to the third connection node that couples the parallel-connected first capacitor and first impedance component with the gate terminal of the first PMOS, and a gate terminal coupled to the gate terminal of the third current NMOS.

The first voltage might be supplied to the first end of the replicated impedance component is lower than the second voltage supplied to the second end of the replicated impedance component.

A detailed description is given in the following embodiments with reference to the accompanying drawings.

### BRIEF DESCRIPTION OF THE DRAWINGS

The present invention can be more fully understood by reading the subsequent detailed description and examples with references made to the accompanying drawings, wherein:
FIG. 1 depicts a circuit 100 with a pseudo class-AB structure, which is not covered by the claimed invention;
FIG. 2A depicts a bias circuit 200 for the low voltage applications, which is covered by the claimed invention;
FIG. 2B depicts how the bias circuit 200 is coupled to the differential amplifier, which is covered by the claimed invention;
FIG. 3A depicts an LDO 300, which is covered by the claimed invention; and
FIG. 3B depicts a bias circuit 302 for the LDO 300, which is covered by the claimed invention.

Hereinafter, whenever an embodiment/example/aspect is described, reference is to be made to the above figure list to determine whether the embodiment/example is to be read as covered by the claimed invention or as an embodiment/example/aspect which is not covered by the claimed invention.

### DETAILED DESCRIPTION OF THE INVENTION

The following description is made for the purpose of illustrating the general principles of the invention and should not be taken in a limiting sense. The scope of the invention is best determined by reference to the appended claims.

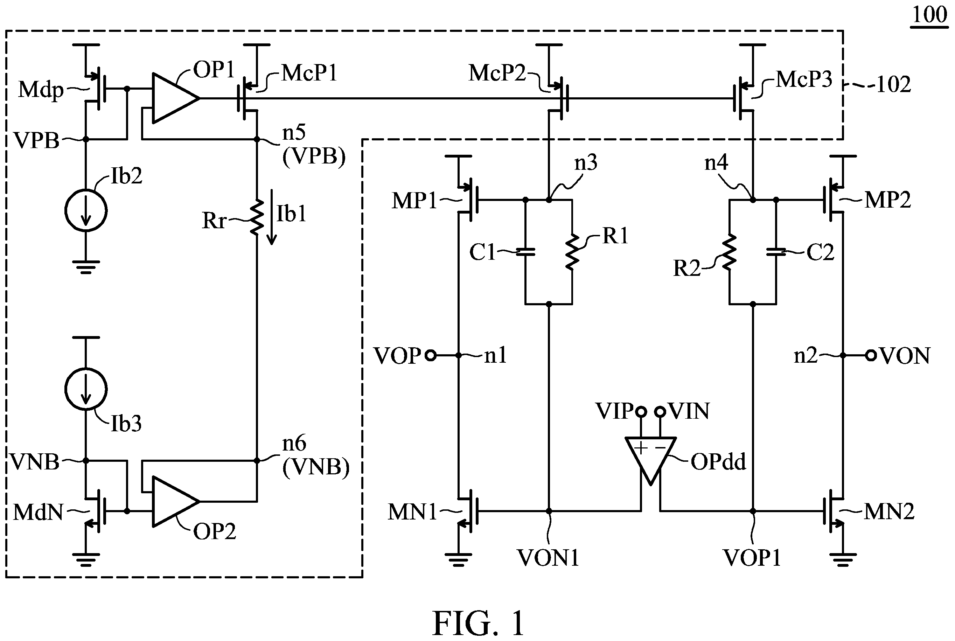

FIG. 1 depicts a circuit 100 with a pseudo class-AB structure. The circuit 100 is implemented as a differential amplifier. The output stage of the circuit 100 has a first PMOS (p-type Metal-Oxide-Semiconductor Field-Effect Transistor) MP1, a first NMOS (n-type MOSFET) MN1, a second PMOS MP2, and a second NMOS MN2. The first connection node n1 between the drain terminal of the first PMOS MP1 and the drain terminal of the first NMOS MN1 is coupled to the first output terminal (VOP) of the circuit 100, which is a positive differential output terminal of the differential amplifier. The second connection node n2 between the drain terminal of the second PMOS MP2 and the drain terminal of the second NMOS MN2 is coupled to the second output terminal (VON) of the circuit 100, which is a negative differential output terminal of the differential amplifier. The first capacitor C1 is coupled between the gate terminal (n3) of the first PMOS MP1 and the gate terminal of the first NMOS MN1. The second capacitor C2 is coupled between the gate terminal (n4) of the second PMOS MP2 and the gate terminal of the second NMOS MN2. In particular, the first impedance component R1 is coupled in parallel with the first capacitor C1 between the gate terminal of the first PMOS MP1 and the gate terminal of the first NMOS MN1, and the second impedance component R2 is coupled in parallel with the second capacitor C2 between the gate terminal of the second PMOS MP2 and the gate terminal of the second NMOS MN2. With the parallel connected capacitor and impedance component (C1//R1 & C2//R2), the output stage is in a class-AB structure.

In an old design without the impedance components R1 and R2, the transconductance Gm of the output stage may be degraded at low frequencies (degraded from (gmₚ+gmₙ) to gmₙ) in high current driving applications (e.g., Wi-Fi 7). Thus, more output stage current is required, and the power consumption and circuit complexity is increased. The proposed pseudo class-AB structure, however, solves these problems.

Even in cases where there is a large load, the impedance components R1 and R2 track the low-frequency signals to maintain the transconductance Gm of the output stage at a high level (gmₙ+gmₚ rather than gmₙ) while the high-frequency signals are dealt with by the capacitors C1 and C2. The parallel connected capacitor and impedance component (C1//R1 & C2//R2) provide all-pass signal paths.

In some other exemplary embodiments, the impedance components R1 and R2 are replaced by triode region MOSs, switched capacitor resistors, and so on.

In FIG. 1, the input stage of the differential amplifier uses a differential-in-and-differential-out operational amplifier OPdd to receive a differential input. The differential-in-and-differential-out operational amplifier OPdd has a positive input terminal '+' receiving a positive signal VIP of the differential input, a negative input terminal '-' receiving a negative signal VIN of the differential input, a positive output terminal (VOP1) coupled to the gate terminal of the second NMOS MN2, and a negative output terminal (VON1) coupled to the gate terminal of the first NMOS MN1. With the parallel connected capacitor and impedance component (C1//R1 & C2//R2), the DC swing and the intermodulation distortion (IM3) of the differential amplifier all are improved in the low frequency region.

FIG. 1 further shows a bias circuit 102 for the differential amplifier. The bias circuit 102 generates a first bias current Ib1 to be mirrored to bias the first impedance component R1, and is also mirrored to bias the second impedance component R2. The bias circuit 102 comprises a replicated impedance component Rr corresponding to the first impedance component (R1/R2). The first end (n5) and second end (n6) of the replicated impedance component are biased at the first voltage VPB and the second voltage VNB, respectively, to determine the first bias current Ib1. In this manner, the first and second impedance components R1 and R2 are well biased. In the output stage, the properly biased complementary MOS gates keep the advantages (power efficiency) of its class-AB structure.

As shown, the bias circuit 102 further has a diode-connected PMOS MdP, a first operational amplifier OP1, and a first current PMOS McP1. The diode-connected PMOS MdP has a source terminal coupled to a power line. The drain terminal and the gate terminal of the diode-connected PMOS MdP are connected together, and the diode-connected PMOS MdP is biased by a second bias current Ib2. The first operational amplifier OP1 has a first input terminal coupled to the gate terminal of the diode-connected PMOS MdP, a second input terminal coupled to the first end (n5) of the replicated impedance component Rr, and an output terminal. The first current PMOS McP1 has a gate terminal coupled to the output terminal of the first operational amplifier OP1, a source terminal coupled to the power line, and a drain terminal coupled to the first end (n5) of the replicated impedance component Rr.

The bias circuit 102 further has a diode-connected NMOS MdN and a second operational amplifier OP2. The diode-connected NMOS MdN has a source terminal coupled to ground. The drain terminal and the gate terminal of the diode-connected NMOS MdN are connected to each other, and the diode-connected NMOS MdN is biased by the third bias current Ib3. The second operational amplifier OP2 has a first input terminal coupled to the gate terminal of the diode-connected NMOS MdN, a second input terminal coupled to the second end (n6) of the replicated impedance component Rr, and an output terminal also connected to the second end (n6) of the replicated impedance component Rr.

In such a design, the first end (n5) of the replicated impedance component Rr is regulated at the first voltage VPB, and the second end (n6) of the replicated impedance component Rr is regulated at the first voltage VNB.

In FIG. 1, the bias circuit 102 further has a second current PMOS McP2 and a third current PMOS McP3 for mirroring the first bias current Ib1. The second current PMOS McP2 has a gate terminal coupled to the gate terminal of the first current PMOS McP1, a source terminal coupled to the power line, and a drain terminal coupled to a third connection node n3 that couples the parallel-connected first capacitor C1 and first impedance component R1 with the gate terminal of the first PMOS MP1. The third current PMOS McP3 has a gate terminal coupled to the gate terminal of the first current PMOS McP1, a source terminal coupled to the power line, and a drain terminal coupled to a fourth connection node n4 that couples the parallel-connected second capacitor C2 and second impedance component R2 with the gate terminal of the second PMOS MP2.

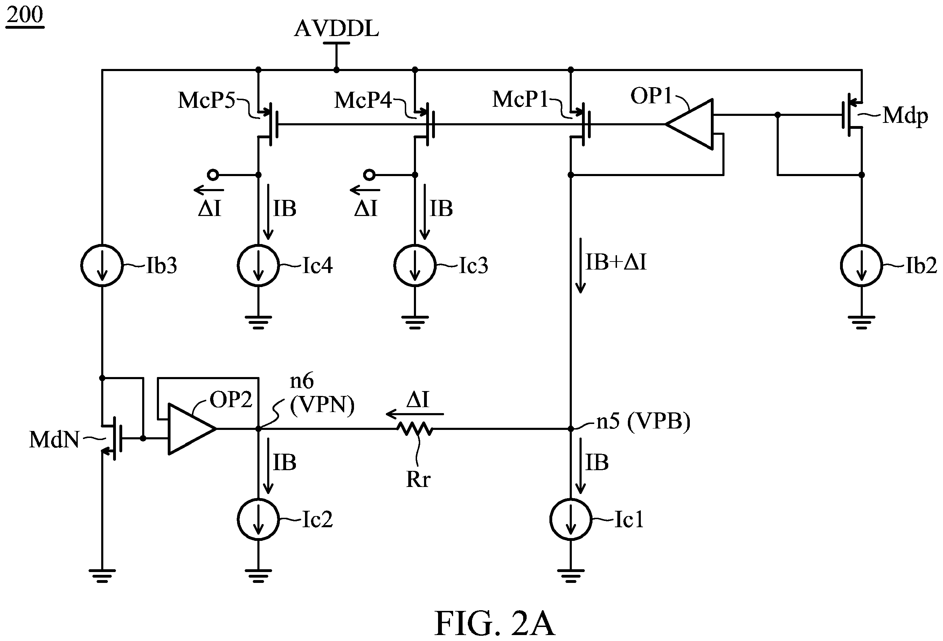

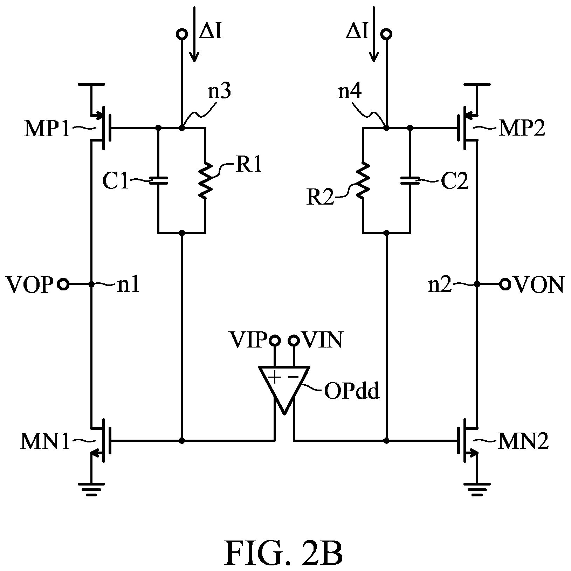

In low voltage domain, the first voltage VPB may be lower than the second voltage VNB. FIG. 2A depicts a bias circuit 200 for the low voltage applications. FIG. 2B depicts how the bias circuit 200 is coupled to the differential amplifier.

As shown in FIG. 2A, the bias circuit 200 has a first current source Ic1 and a second current source Ic2. The first current source Ic1 drains a first current from a fifth connection node n5 between the drain terminal of the first current PMOS McP1 and the first end of the replicated impedance component Rr. The second current source Ic2 drains a second current from a sixth connection node n6 between the output terminal of the second operational amplifier OP2 and the second end of the replicated impedance component Rr.

The bias circuit 200 further has a fourth current PMOS McP4 and a third current source Ic3. The fourth current PMOS McP4 has a gate terminal coupled to the gate terminal of the first current PMOS McP1, a source terminal coupled to the power line, and a drain terminal. The third current source Ic3 drains a third current from the drain terminal of the fourth current PMOS McP4. The drain terminal of the fourth current PMOS McP4 is coupled to the third connection node n3 of the differential amplifier as presented in FIG. 2B.

The bias circuit 200 further has a fifth current PMOS McP5 and a fourth current source Ic4. The fifth current PMOS McP5 has a gate terminal coupled to the gate terminal of the first current PMOS McP1, a source terminal coupled to the power line, and a drain terminal. The fourth current source Ic4 drains a fourth current from the drain terminal of the fifth current PMOS McP5. The drain terminal of the fifth current PMOS McP5 is coupled to the fourth connection node n4 of the differential amplifier as presented in FIG. 2B.

In FIG. 2A, the first current source Ic1, the second current source Ic2, the third current source Ic3, and the fourth current source Ic4 are of the same current value IB. Thus, no matter the first voltage VPB is greater or lower than the second voltage VNB, the current ΔI flowing through the replicated impedance component Rr is successfully mirrored to the first impedance component R1 and the second impedance component R2.

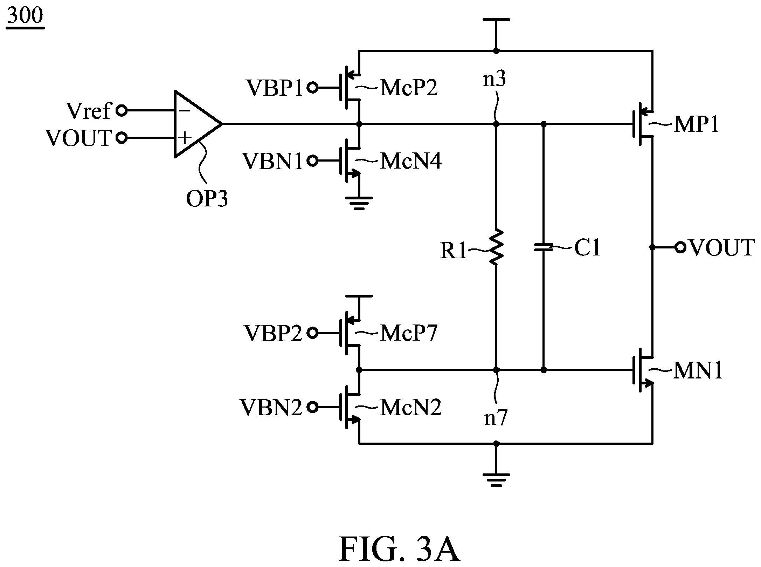

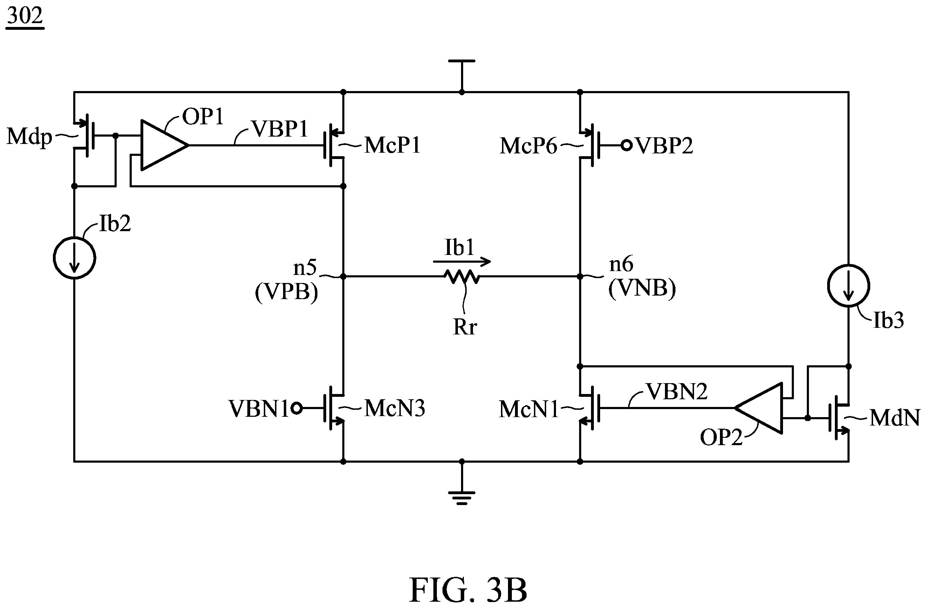

The pseudo class-AB structure may be used in a single-end circuit, such as a low dropout regulator (LDO). FIG. 3A depicts an LDO 300, and FIG. 3B depicts a bias circuit 302 for the LDO 300.

The LDO 300 includes a class-AB structure (formed by MP1, MN1, C1, and R1) and a third operational amplifier OP3. The third operational amplifier OP3 has a positive input terminal '+' for feedback of the LDO voltage VOUT, a negative input terminal '-' biased at a reference voltage Vref, and an output terminal coupled to the gate terminal of the first PMOS MP1.

In comparison with the bias circuit 200 shown in FIG. 2A, the bias circuit 302 further has a first current NMOS McN1, having a gate terminal coupled to the output terminal of the second operational amplifier OP2, a source terminal coupled to the ground, and a drain terminal coupled to the second end (n6) of the replicated impedance component Rr, and an output terminal.

For mirroring the first bias current Ib1 (flowing through the replicated impedance component Rr) to the first impedance component R1 of the LDO 300, the LDO 300 of FIG. 3A further has a second current PMOS McP2 and a second current NMOS McN2. The second current PMOS McP2 has a gate terminal coupled to the gate terminal of the first current PMOS McP1 of FIG. 3B (biased at VBP1), a source terminal coupled to the power line, and a drain terminal coupled to the third connection node n3. The second current NMOS McN2 has a gate terminal coupled to the gate terminal of the first current NMOS McN1 of FIG. 3B

(biased at VBN2), a source terminal coupled to the ground, and a drain terminal coupled to a seventh connection node n7 that couples the parallel-connected first capacitor C1 and first impedance component R1 with the gate terminal of the first NMOS MN1.

Especially, for low voltage applications, the bias circuit 302 of FIG. 3B further has a sixth current PMOS McP6 and a third current NMOS McN3. The sixth current PMOS McP6 has a source terminal coupled to the power line, a drain terminal coupled to the second end (n6) of the replicated impedance component Rr, and a gate terminal. The third current NMOS McN3 has a source terminal coupled to the ground, a drain terminal coupled to the first end (n5) of the replicated impedance component Rr, and a gate terminal. Correspondingly, the LDO 300 of FIG. 3A has a seventh current PMOS McP7 and a fourth current NMOS Mcn4. The seventh current PMOS McP7 has a source terminal coupled to the power line, a drain terminal coupled to the seventh connection node n7, and a gate terminal coupled to the gate terminal of the sixth current PMOS McP6 of FIG. 3B (biased at VBP2). The fourth current NMOS McN4 has a source terminal coupled to the ground, a drain terminal coupled to the third connection node n3, and a gate terminal coupled to the gate terminal of the third current NMOS McN3 of FIG. 3B (biased at VBN1). In an exemplary embodiment, VBP2 and VBN1 are biased for generation of the same current values.

Any circuit with the proposed pseudo class-AB structure (have the parallel-connected capacitor and impedance component between the gates of the complementary MOS gates) should be considered within the scope of the present invention.

While the invention has been described by way of example and in terms of the preferred embodiments, it should be understood that the invention is not limited to the disclosed embodiments. On the contrary, it is intended to cover various modifications and similar arrangements (as would be apparent to those skilled in the art). Therefore, the scope of the appended claims should be accorded the broadest interpretation so as to encompass all such modifications and similar arrangements.

## Claims

1. A circuit with a pseudo class-AB structure, comprising:
an output stage, having a first p-type Metal-Oxide-Semiconductor Field-Effect Transistor, PMOS, (MP1) and a first n-type Metal-Oxide-Semiconductor Field-Effect Transistor, NMOS, (MN1), wherein
a first connection node (n1) between a drain terminal of the first PMOS and a drain terminal of the first NMOS is coupled to a first output terminal (VOP) of the circuit;
a first capacitor (C1), and a first impedance component (R1) coupled in parallel between a gate terminal of the first PMOS and a gate terminal of the first NMOS; and
a bias circuit, generating a first bias current (ΔI) to be mirrored to bias the first impedance component, wherein the bias circuit comprises a replicated impedance component (Rr) corresponding to the first impedance component, and a first end and a second end of the replicated impedance component are biased at a first voltage (VPB) and a second voltage (VPN), respectively, to determine the first bias current;
wherein the bias circuit further comprises:
a diode-connected PMOS (Mdp) having a source terminal coupled to a power line (AVDDL), a drain terminal and a gate terminal connected together, and biased by a second bias current (Ib2);
a first operational amplifier (OP1), having a first input terminal coupled to the gate terminal of the diode-connected PMOS (Mdp), a second input terminal coupled to the first end (n5) of the replicated impedance component (Rr), and an output terminal;
a first current PMOS (McP1), having gate terminal coupled to the output terminal of the first operational amplifier (OP1), and a drain terminal coupled to the first end of the replicated impedance component;
a first current source (Ic1), draining a first current (IB) from a fifth connection node (n5) between the drain terminal of the first current PMOS and the first end of the replicated impedance component;
a fourth current PMOS (McP4), having a gate terminal coupled to a gate terminal of the first current PMOS, a source terminal coupled to the power line (AVDDL), and a drain terminal; and
a third current source (Ic3), draining a third current (IB) from the drain terminal of the fourth current PMOS;
wherein the drain terminal of the fourth current PMOS is coupled to a third connection node (n3) that couples the parallel-connected first capacitor and first impedance component with the gate terminal of the first PMOS; and
wherein the first current (IB) and the third current (IB) are of the same current value.

2. The circuit as claimed in claim 1, further comprising:
a second capacitor (C2); and
a second impedance component (R2);
wherein:
the circuit is implemented as a differential amplifier;
the output stage further has a second PMOS (MP2) and a second NMOS (MN2), wherein a second connection node (n2) between a drain terminal of the second PMOS and a drain terminal of the second NMOS is coupled to a second output terminal (VON) of the circuit;
the second capacitor and the second impedance component are coupled in parallel between a gate terminal of the second PMOS and a gate terminal of the second NMOS;
the first output terminal of the circuit is a positive differential output terminal; and
the second output terminal of the circuit is a negative differential output terminal.

3. The circuit as claimed in claim 2, wherein the first bias current (ΔI) is further mirrored to bias the second impedance component,
wherein:
the replicated impedance component also corresponds to the second impedance component.

4. The circuit as claimed in claim 3, further comprising:
an input stage, receiving a differential input,
wherein the input stage is coupled to the output stage through the gate terminal of the first NMOS and the gate terminal of the second NMOS.

5. The circuit as claimed in claim 4, wherein:
the input stage includes a differential-in-and-differential-out operational amplifier (OPdd), having a positive input terminal (VIP) receiving a positive signal of the differential input, a negative input terminal (VIN) receiving a negative signal of the differential input, a positive output terminal coupled to the gate terminal of the second NMOS, and a negative output terminal coupled to the gate terminal of the first NMOS.

6. The circuit as claimed in any of the preceding claims, wherein the bias circuit further comprises:
a diode-connected NMOS (MdN), having a source terminal coupled to ground, wherein a drain terminal and a gate terminal of the diode-connected NMOS are connected with each other, and the diode-connected NMOS is biased by a third bias current (Ib3); and
a second operational amplifier (OP2), having a first input terminal coupled to the gate terminal of the diode-connected NMOS, a second input terminal coupled to the second end of the replicated impedance component, and an output terminal also connected to the second end of the replicated impedance component.

7. The circuit as claimed in claim 6, wherein the bias circuit further comprises:
a second current source (Ic2), draining a second current (IB) from a sixth connection node (n6) between the output terminal of the second operational amplifier and the second end of the replicated impedance component.

8. The circuit as claimed in claims 2 to 7, wherein the bias circuit further comprises:
a fifth current PMOS (McP5), having a gate terminal coupled to the gate terminal of the first current PMOS, a source terminal coupled to the power line, and a drain terminal; and
a fourth current source (Ic4), draining a fourth current (IB) from the drain terminal of the fifth current PMOS;
wherein the drain terminal of the fifth current PMOS is coupled to a fourth connection node (n4) that couples the parallel-connected second capacitor and second impedance component with the gate terminal of the second PMOS.

9. The circuit as claimed in any of the preceding claims, wherein:
the first voltage supplied to the first end of the replicated impedance component is lower than the second voltage supplied to the second end of the replicated impedance component.

10. The circuit as claimed in claim 8 when dependent on claim 7, wherein:
the second current source, and the fourth current source are of the same current value as the first current source.

## Patentansprüche

1. Schaltung mit einer Pseudo-Klasse-AB-Struktur, umfassend:
eine Ausgangsstufe, die einen ersten p-Kanal-Metall-Oxid-Halbleiter-Feldeffekttransistor, PMOS, (MP1) und einen ersten n-Kanal-Metall-Oxid-Halbleiter-Feldeffekttransistor, NMOS, (MN1) aufweist, wobei
ein erster Verbindungsknoten (n1) zwischen einem Drain-Anschluss des ersten PMOS und einem Drain-Anschluss des ersten NMOS mit einem ersten Ausgangsanschluss (VOP) der Schaltung gekoppelt ist;
ein erster Kondensator (C1) und eine erste Impedanzkomponente (R1), die zwischen einem Gate-Anschluss des ersten PMOS und einem Gate-Anschluss des ersten NMOS parallelgeschaltet sind; und
eine Vorspannungsschaltung, die einen ersten Vorspannungsstrom (ΔI) erzeugt, der gespiegelt werden soll, um die erste Impedanzkomponente vorzuspannen, wobei die Vorspannungsschaltung eine nachgebildete Impedanzkomponente (Rr) umfasst, die der ersten Impedanzkomponente entspricht, und ein erstes Ende und ein zweites Ende der nachgebildeten Impedanzkomponente auf eine erste Spannung (VPB) bzw. eine zweite Spannung (VPN) vorgespannt sind, um den ersten Vorspannungsstrom zu bestimmen; wobei die Vorspannungsschaltung weiter umfasst:
einen als Diode geschalteten PMOS (Mdp), der einen Source-Anschluss, der mit einer Versorgungsleitung (AVDDL) gekoppelt ist, einen Drain-Anschluss und einen Gate-Anschluss, die miteinander verbunden sind, aufweist und durch einen zweiten Vorspannungsstrom (Ib2) vorgespannt ist;
einen ersten Operationsverstärker (OP1), der einen ersten Eingangsanschluss, der mit dem Gate-Anschluss des als Diode geschalteten PMOS (Mdp) gekoppelt ist, einen zweiten Eingangsanschluss, der mit dem ersten Ende (n5) der nachgebildeten Impedanzkomponente (Rr) gekoppelt ist, und einen Ausgangsanschluss aufweist;
einen ersten Strom-PMOS (McPl), der einen Gate-Anschluss, der mit dem Ausgangsanschluss des ersten Operationsverstärkers (OP1) gekoppelt ist, und einen Drain-Anschluss, der mit dem ersten Ende der nachgebildeten Impedanzkomponente gekoppelt ist, aufweist;
eine erste Stromquelle (Ic1), die einen ersten Strom (IB) aus einem fünften Verbindungsknoten (n5) zwischen dem Drain-Anschluss des ersten Strom-PMOS und dem ersten Ende der nachgebildeten Impedanzkomponente ableitet;
einen vierten Strom-PMOS (McP4), der einen Gate-Anschluss, der mit einem Gate-Anschluss des ersten Strom-PMOS gekoppelt ist, einen Source-Anschluss, der mit der Versorgungsleitung (AVDDL) gekoppelt ist, und einen Drain-Anschluss aufweist; und
eine dritte Stromquelle (Ic3), die einen dritten Strom (IB) von dem Drain-Anschluss des vierten Strom-PMOS ableitet;
wobei der Drain-Anschluss des vierten Strom-PMOS mit einem dritten Verbindungsknoten (n3) gekoppelt ist, der den parallel geschalteten ersten Kondensator und die erste Impedanzkomponente mit dem Gate-Anschluss des ersten PMOS koppelt; und
wobei der erste Strom (IB) und der dritte Strom (IB) denselben Stromwert aufweisen.

2. Schaltung nach Anspruch 1, weiter umfassend:
einen zweiten Kondensator (C2); und
eine zweite Impedanzkomponente (R2);
wobei:
die Schaltung als Differenzverstärker ausgeführt ist;
die Ausgangsstufe weiter einen zweiten PMOS (MP2) und einen zweiten NMOS (MN2) aufweist, wobei ein zweiter Verbindungsknoten (n2) zwischen einem Drain-Anschluss des zweiten PMOS und einem Drain-Anschluss des zweiten NMOS mit einem zweiten Ausgangsanschluss (VON) der Schaltung gekoppelt ist;
der zweite Kondensator und die zweite Impedanzkomponente zwischen einem Gate-Anschluss des zweiten PMOS und einem Gate-Anschluss des zweiten NMOS parallelgeschaltet sind;
der erste Ausgangsanschluss der Schaltung ein positiver differenzieller Ausgangsanschluss ist; und
der zweite Ausgangsanschluss der Schaltung ein negativer differenzieller Ausgangsanschluss ist.

3. Schaltung nach Anspruch 2, wobei der erste Vorspannungsstrom (ΔI) weiter gespiegelt wird, um die zweite Impedanzkomponente vorzuspannen,
wobei:
die nachgebildete Impedanzkomponente auch der zweiten Impedanzkomponente entspricht.

4. Schaltung nach Anspruch 3, weiter umfassend:
eine Eingangsstufe, die einen differenziellen Eingang empfängt,
wobei die Eingangsstufe über den Gate-Anschluss des ersten NMOS und den Gate-Anschluss des zweiten NMOS mit der Ausgangsstufe gekoppelt ist.

5. Schaltung nach Anspruch 4, wobei:
die Eingangsstufe einen Operationsverstärker mit differenziellem Eingang und differenziellem Ausgang (OPdd) einschließt, der einen positiven Eingangsanschluss (VIP), der ein positives Signal des differenziellen Eingangs empfängt, einen negativen Eingangsanschluss (VIN), der ein negatives Signal des differenziellen Eingangs empfängt, einen positiven Ausgangsanschluss, der mit dem Gate-Anschluss des zweiten NMOS gekoppelt ist, und einen negativen Ausgangsanschluss, der mit dem Gate-Anschluss des ersten NMOS gekoppelt ist, aufweist.

6. Schaltung nach einem der vorstehenden Ansprüche, wobei die Vorspannungsschaltung weiter umfasst:
einen als Diode geschalteten NMOS (MdN), der einen Source-Anschluss aufweist, der mit Masse gekoppelt ist, wobei ein Drain-Anschluss und ein Gate-Anschluss des als Diode geschalteten NMOS miteinander verbunden sind, und der als Diode geschaltete NMOS durch einen dritten Vorspannungsstrom (Ib3) vorgespannt ist; und
einen zweiten Operationsverstärker (OP2), der einen ersten Eingangsanschluss, der mit dem Gate-Anschluss des als Diode geschalteten NMOS gekoppelt ist, einen zweiten Eingangsanschluss, der mit dem zweiten Ende der nachgebildeten Impedanzkomponente gekoppelt ist, und einen Ausgangsanschluss, der ebenfalls mit dem zweiten Ende der nachgebildeten Impedanzkomponente verbunden ist, aufweist.

7. Schaltung nach Anspruch 6, wobei die Vorspannungsschaltung weiter umfasst: eine zweite Stromquelle (Ic2), die einen zweiten Strom (IB) aus einem sechsten Verbindungsknoten (n6) zwischen dem Ausgangsanschluss des zweiten Operationsverstärkers und dem zweiten Ende der nachgebildeten Impedanzkomponente ableitet.

8. Schaltung nach den Ansprüchen 2 bis 7, wobei die Vorspannungsschaltung weiter umfasst:
einen fünften Strom-PMOS (McP5), der einen Gate-Anschluss, der mit dem Gate-Anschluss des ersten Strom-PMOS gekoppelt ist, einen Source-Anschluss, der mit der Versorgungsleitung gekoppelt ist, und einen Drain-Anschluss aufweist; und
eine vierte Stromquelle (Ic4), die einen vierten Strom (IB) von dem Drain-Anschluss des fünften Strom-PMOS ableitet;
wobei der Drain-Anschluss des fünften Strom-PMOS mit einem vierten Verbindungsknoten (n4) gekoppelt ist, der den parallel geschalteten zweiten Kondensator und die zweite Impedanzkomponente mit dem Gate-Anschluss des zweiten PMOS koppelt.

9. Schaltung nach einem der vorstehenden Ansprüche, wobei:
die dem ersten Ende der nachgebildeten Impedanzkomponente zugeführte erste Spannung niedriger ist als die dem zweiten Ende der nachgebildeten Impedanzkomponente zugeführte zweite Spannung.

10. Schaltung nach Anspruch 8, wenn abhängig von Anspruch 7, wobei:
die zweite Stromquelle und die vierte Stromquelle denselben Stromwert wie die erste Stromquelle aufweisen.

## Revendications

1. Circuit avec une structure de pseudo classe AB, comprenant :
un étage de sortie, ayant un premier transistor à effet de champ métal-oxyde-semiconducteur de type p, PMOS, (MP1) et un premier transistor à effet de champ métal-oxyde-semiconducteur de type n, NMOS, (MN1), dans lequel
un premier nœud de connexion (n1) entre une borne de drain du premier PMOS et une borne de drain du premier NMOS est couplé à une première borne de sortie (VOP) du circuit ;
un premier condensateur (C1), et un premier composant d'impédance (R1) couplés en parallèle entre une borne de grille du premier PMOS et une borne de grille du premier NMOS ; et
un circuit de polarisation, générant un premier courant de polarisation (ΔI) à recopier par miroir pour polariser le premier composant d'impédance, dans lequel le circuit de polarisation comprend un composant d'impédance répliqué (Rr) correspondant au premier composant d'impédance, et une première extrémité et une deuxième extrémité du composant d'impédance répliqué sont polarisées à une première tension (VPB) et à une deuxième tension (VPN), respectivement, pour déterminer le premier courant de polarisation ;
dans lequel le circuit de polarisation comprend en outre :
un PMOS monté en diode (Mdp) ayant une borne de source couplée à une ligne d'alimentation (AVDDL), une borne de drain et une borne de grille connectées ensemble, et polarisé par un deuxième courant de polarisation (Ib2) ;
un premier amplificateur opérationnel (OP1), ayant une première borne d'entrée couplée à la borne de grille du PMOS monté en diode (Mdp), une deuxième borne d'entrée couplée à la première extrémité (n5) du composant d'impédance répliqué (Rr), et une borne de sortie ;
un premier PMOS de courant (McP1), ayant une borne de grille couplée à la borne de sortie du premier amplificateur opérationnel (OP1), et une borne de drain couplée à la première extrémité du composant d'impédance répliqué ;
une première source de courant (Ic1), soutirant un premier courant (IB) d'un cinquième nœud de connexion (n5) entre la borne de drain du premier PMOS de courant et la première extrémité du composant d'impédance répliqué ;
un quatrième PMOS de courant (McP4), ayant une borne de grille couplée à une borne de grille du premier PMOS de courant, une borne de source couplée à la ligne d'alimentation (AVDDL), et une borne de drain ; et
une troisième source de courant (Ic3), soutirant un troisième courant (IB) de la borne de drain du quatrième PMOS de courant ;
dans lequel la borne de drain du quatrième PMOS de courant est couplée à un troisième nœud de connexion (n3) qui couple le premier condensateur et le premier composant d'impédance connectés en parallèle à la borne de grille du premier PMOS ; et
dans lequel le premier courant (IB) et le troisième courant (IB) sont de la même valeur de courant.

2. Circuit selon la revendication 1, comprenant en outre :
un deuxième condensateur (C2) ; et
un deuxième composant d'impédance (R2) ;
dans lequel :
le circuit est mis en œuvre sous la forme d'un amplificateur différentiel ;
l'étage de sortie présente en outre un deuxième PMOS (MP2) et un deuxième NMOS (MN2), dans lequel un deuxième nœud de connexion (n2) entre une borne de drain du deuxième PMOS et une borne de drain du deuxième NMOS est couplé à une deuxième borne de sortie (VON) du circuit ;
le deuxième condensateur et le deuxième composant d'impédance sont couplés en parallèle entre une borne de grille du deuxième PMOS et une borne de grille du deuxième NMOS ;
la première borne de sortie du circuit est une borne de sortie différentielle positive ; et
la deuxième borne de sortie du circuit est une borne de sortie différentielle négative.

3. Circuit selon la revendication 2, dans lequel le premier courant de polarisation (ΔI) est en outre recopié par miroir pour polariser le deuxième composant d'impédance,
dans lequel :
le composant d'impédance répliqué correspond également au deuxième composant d'impédance.

4. Circuit selon la revendication 3, comprenant en outre :
un étage d'entrée, recevant une entrée différentielle,
dans lequel l'étage d'entrée est couplé à l'étage de sortie par l'intermédiaire de la borne de grille du premier NMOS et de la borne de grille du deuxième NMOS.

5. Circuit selon la revendication 4, dans lequel :
l'étage d'entrée inclut un amplificateur opérationnel à entrée différentielle et à sortie différentielle (OPdd), ayant une borne d'entrée positive (VIP) recevant un signal positif de l'entrée différentielle, une borne d'entrée négative (VIN) recevant un signal négatif de l'entrée différentielle, une borne de sortie positive couplée à la borne de grille du deuxième NMOS, et une borne de sortie négative couplée à la borne de grille du premier NMOS.

6. Circuit selon l'une quelconque des revendications précédentes, dans lequel le circuit de polarisation comprend en outre :
un NMOS monté en diode (MdN), ayant une borne de source couplée à la masse, dans lequel une borne de drain et une borne de grille du NMOS monté en diode sont connectées l'une à l'autre, et le NMOS monté en diode est polarisé par un troisième courant de polarisation (Ib3) ; et
un deuxième amplificateur opérationnel (OP2), ayant une première borne d'entrée couplée à la borne de grille du NMOS monté en diode, une deuxième borne d'entrée couplée à la deuxième extrémité du composant d'impédance répliqué, et une borne de sortie également connectée à la deuxième extrémité du composant d'impédance répliqué.

7. Circuit selon la revendication 6, dans lequel le circuit de polarisation comprend en outre : une deuxième source de courant (Ic2), soutirant un deuxième courant (IB) d'un sixième nœud de connexion (n6) entre la borne de sortie du deuxième amplificateur opérationnel et la deuxième extrémité du composant d'impédance répliqué.

8. Circuit selon les revendications 2 à 7, dans lequel le circuit de polarisation comprend en outre :
un cinquième PMOS de courant (McP5), ayant une borne de grille couplée à la borne de grille du premier PMOS de courant, une borne de source couplée à la ligne d'alimentation, et une borne de drain ; et
une quatrième source de courant (Ic4), soutirant un quatrième courant (IB) de la borne de drain du cinquième PMOS de courant ;
dans lequel la borne de drain du cinquième PMOS de courant est couplée à un quatrième nœud de connexion (n4) qui couple le deuxième condensateur et le deuxième composant d'impédance connectés en parallèle à la borne de grille du deuxième PMOS.

9. Circuit selon l'une quelconque des revendications précédentes, dans lequel :
la première tension fournie à la première extrémité du composant d'impédance répliqué est inférieure à la deuxième tension fournie à la deuxième extrémité du composant d'impédance répliqué.

10. Circuit selon la revendication 8 lorsqu'elle dépend de la revendication 7, dans lequel :
la deuxième source de courant, et la quatrième source de courant sont de la même valeur de courant que la première source de courant.
